# EUROPEAN PATENT APPLICATION

(11) **EP 4 495 285 A1**
(43) Date of publication of application: **22.01.2025**
(21) Application number: 24180442.6
(22) Date of filing: 06.06.2024
(51) Int. Cl.: C23C 14/04

(54) **MASK ASSEMBLY AND METHOD OF MANUFACTURING THE SAME**

(30) Priority: 22.06.2023 KR 20230080334
(71) Applicant: Samsung Display Co., Ltd., Yongin-si, Gyeonggi-do 17113 (KR)
(72) Inventor: HONG, Seungju, 17113 Giheung-Gu, Yongin-si, Gyeonggi-Do (KR); LEE, Jongdae, 17113 Giheung-gu, Yongin-si, Gyeonggi-Do (KR); MIN, Soohyun, 17113 Giheung-gu, Yongin-si, Gyeonggi-Do (KR); PARK, Jongsung, 17113 Giheung-gu, Yongin-si, Gyeonggi-Do (KR); WOO, Mina, 17113 Giheung-Gu, Yongin-si, Gyeonggi-Do (KR); JANG, Wonyoung, 17113 Giheung-Gu, Yongin-si, Gyeonggi-Do (KR)
(74) Representative: Dr. Weitzel & Partner

(57) **Abstract**

A mask assembly includes a mask frame including a frame opening, a first stick disposed on the mask frame, overlapping the frame opening, and extending in a first direction to have a first length, a second stick disposed on the first stick, overlapping the frame opening, and extending in a second direction intersecting the first direction to have a second length longer than the first length, and a mask disposed on the second stick and including a mask opening overlapping the frame opening. The second stick includes a first center portion crossing the frame opening and a first end portion extending from the first center portion in the second direction.

## Description

### BACKGROUND

### 1. Technical Field

Embodiments relate to a mask assembly and a method of manufacturing the mask assembly. More particularly, the embodiments relate to a mask assembly including a stick having a notch shape and a method of manufacturing the mask assembly.

### 2. Description of the Related Art

Display devices output a video or image through a display area thereof to provide various visual information to a user. Among the display devices, an organic light emitting display device has advantages of a wide viewing angle, an excellent contrast, and a fast response speed. The display area of the organic light emitting display device includes pixels, and the pixels are formed in the display area by a deposition process using a deposition material. As an example, an organic material is deposited on a substrate using a fine metal mask (FMM) to form a thin film with a desired pattern.

In case that the organic material is deposited, a support stick is disposed between a mask assembly and a mask to form a non-active area through which no deposition material passes in the display area. For example, the support stick is deformed by tensile force applied thereto, and an organic material is not deposited at a desired location due to deformation caused by the tensile force.

### SUMMARY

Embodiments provide a mask assembly capable of adjusting a degree of bending of a support stick by applying a differential tensile force.

Embodiments provide a method of manufacturing the mask assembly to adjust the degree of bending deformation of the support stick.

However, embodiments of the invention are not limited to those set forth herein. The above and other embodiments will become more apparent to one of ordinary skill in the art to which the invention pertains by referencing the detailed description of the invention given below.

The invention is defined by the independent claims. According to a first aspect of the invention, a mask assembly includes a mask frame including a frame opening, a first stick disposed on the mask frame, overlapping the frame opening, and extending in a first direction to have a first length, a second stick disposed on the first stick, overlapping the frame opening, and extending in a second direction intersecting the first direction to have a second length longer than the first length, and a mask disposed on the second stick and including a mask opening overlapping the frame opening. The second stick includes a first center portion crossing the frame opening and a first end portion extending from the first center portion in the second direction. The first end portion includes a first notch concave portion in which a central portion of an outer side surface of the first end portion is recessed toward the first center portion when viewed in a plane, and a maximum width of the first notch concave portion is substantially equal to or greater than about 40% of a width of the first end portion when viewed in the plane.

The maximum width of the first notch concave portion may be smaller than about 80% of the width of the first end portion when viewed in the plane.

The first notch concave portion may include a first-first notch concave portion having a substantially uniform width when viewed in the plane and a first-second notch concave portion having a width which decreases as a distance from the first center portion decreases when viewed in the plane.

The first-second notch concave portion may be a curved line having a substantially uniform curvature when viewed in the plane, and the substantially uniform curvature may be about 0.5 times the maximum width of the first notch concave portion when viewed in the plane.

A length of the first-first notch concave portion in the second direction may be substantially equal to or greater than about 8 mm and substantially equal to or smaller than about 12 mm when viewed in the plane.

The width of the first end portion may be substantially equal to or greater than about 25 mm.

A minimum width of the first center portion may be substantially equal to or smaller than about 5 mm.

A width of the first center portion in the first direction decreases as a distance from the first end portion increases.

The first end portion may include first and second portions protruding outward from the first center portion, the first notch concave portion may be defined between the first and second portions, and a thickness of each of the first and second portions may be substantially uniform in the second direction when viewed in the plane.

The thickness of the first portion may be substantially equal to the thickness of the second portion when viewed in the plane.

The mask may include a plurality of masks, the first stick may include a plurality of first sticks, the second stick may include a plurality of second sticks, the first sticks may be arranged in the second direction, the second sticks may be arranged in the first direction, and the masks may be arranged in the second direction.

The mask and the mask frame may include Invar.

The first stick may include a second center portion crossing the frame opening and a second end portion extending from the second center portion in the first direction, the second end portion may include a second notch concave portion in which a central portion of an outer side surface of the second end portion is recessed toward the second center portion when viewed in the plane, and a maximum width of the second notch concave portion may be substantially equal to or greater than about 40% of a width of the second end portion when viewed in the plane.

The maximum width of the second notch concave portion may be smaller than about 80% of the width of the second end portion when viewed in the plane.

The second end portion may include third and fourth portions protruding outward from the second center portion, the second notch concave portion may be defined between the third and fourth portions, and a thickness of each of the third and fourth portions may be substantially uniform in the first direction when viewed in the plane.

The thickness of the third portion may be substantially equal to the thickness of the fourth portion when viewed in the plane.

According to a second aspect of the invention, a method of manufacturing a mask assembly includes disposing a first stick extending in a first direction to have a first length on a mask frame including a frame opening, disposing a second stick including a first center portion crossing the frame opening and a first end portion extending from the first center portion in a second direction and extending in the second direction intersecting the first direction to have a second length longer than the first length on the first stick, fixing a first portion of the first end portion by a first clamp and a second portion of the first end portion by a second clamp, respectively, to apply a tensile force to the first and second portions, and attaching a mask disposed on the second stick and including a mask opening overlapping the frame opening to the mask frame. The first end portion includes a first notch concave portion in which a center portion of an outer side surface of the first end portion is recessed toward the first center portion when viewed in a plane, and a maximum width of the first notch concave portion is substantially equal to or greater than about 40% of a width of the first end portion when viewed in the plane.

The first clamp may apply a first tensile force to the first portion, and the second clamp may apply a second tensile force greater than the first tensile force to the second portion.

According to the mask assembly or the method, the first notch concave portion may be disposed between the first portion and the second portion, and a thickness of each of the first and second portions may be substantially uniform in the second direction when viewed in the plane.

According to the mask assembly or the method, a length in the second direction of each of the first and second portions may be substantially equal to or greater than about 10 mm.

According to the mask assembly, the second stick may include the first notch concave portion defined in the first end portion and the first and second portions protruded with the first notch concave portion disposed therebetween, and the tensile forces of different magnitude may be applied to the first portion and the second portion. Since the first end portion has the notch shape, a degree of bending of the second stick according to the differential tensile force may increase. Thus, a degree of bending of the second stick may be able to be adjusted.

According to the method of manufacturing the mask assembly, the mask assembly that is capable of adjusting the degree of bending of the second stick is provided.

### BRIEF DESCRIPTION OF THE DRAWINGS

The above and other advantages of the invention will become readily apparent by reference to the following detailed description when considered in conjunction with the accompanying drawings wherein:
FIG. 1 is a schematic cross-sectional view of a deposition apparatus according to an embodiment;
FIG. 2 is a schematic perspective view of a mask assembly according to an embodiment;
FIG. 3 is an exploded schematic perspective view of a mask assembly according to an embodiment;
FIG. 4 is an enlarged schematic plan view of a portion of a second stick according to an embodiment;
FIG. 5A is a schematic plan view of the second stick before being bent according to an embodiment;
FIG. 5B is a schematic plan view of the second stick after being bent according to an embodiment;
FIG. 6A is a schematic plan view of a second stick in which a notch concave portion is not defined;
FIG. 6B is a schematic plan view of a second stick in which a notch concave portion is not defined and to which a differential tensile force is applied;
FIG. 6C is a schematic plan view of a second stick after being bent;
FIG. 6D is a graph illustrating a degree of bending of the second stick as a function of a width of the second stick of 6B;
FIG. 7A is a schematic plan view of a second stick according to an embodiment;
FIG. 7B is a schematic plan view of a second stick to which a differential tensile force is applied according to an embodiment;
FIG. 7C is a schematic plan view of a second stick before and after being bent according to an embodiment;
FIG. 7D is a graph illustrating a degree of bending of the second stick as a function of a ratio of a width of a first notch concave portion to a width of a first end portion in case that the width of the second stick of FIG. 7B is changed according to an embodiment;
FIG. 8 is a schematic perspective view of a mask assembly according to an embodiment;
FIG. 9 is an enlarged schematic plan view of a portion of a first stick according to an embodiment;
FIGS. 10A, 10B, 10C, 10D, and 10E are schematic views illustrating a method of manufacturing a mask assembly according to an embodiment;
FIG. 11 is a schematic perspective view of an electronic device according to an embodiment;
FIG. 12 is an exploded schematic perspective view of an electronic device according to an embodiment; and
FIG. 13 is a schematic cross-sectional view of a display panel according to an embodiment.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. Here, various embodiments do not have to be exclusive nor limit the invention. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element (or a layer) is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the X, Y, and Z - axes, and may be interpreted in a broader sense. For example, the DR1-axis, the DR2-axis, and the DR3-axis may be perpendicular to one another, or may represent different directions that are not perpendicular to one another. For the purposes of this invention, "at least one of A and B" may be construed as understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the invention.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein are interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, embodiments will be described with reference to accompanying drawings.

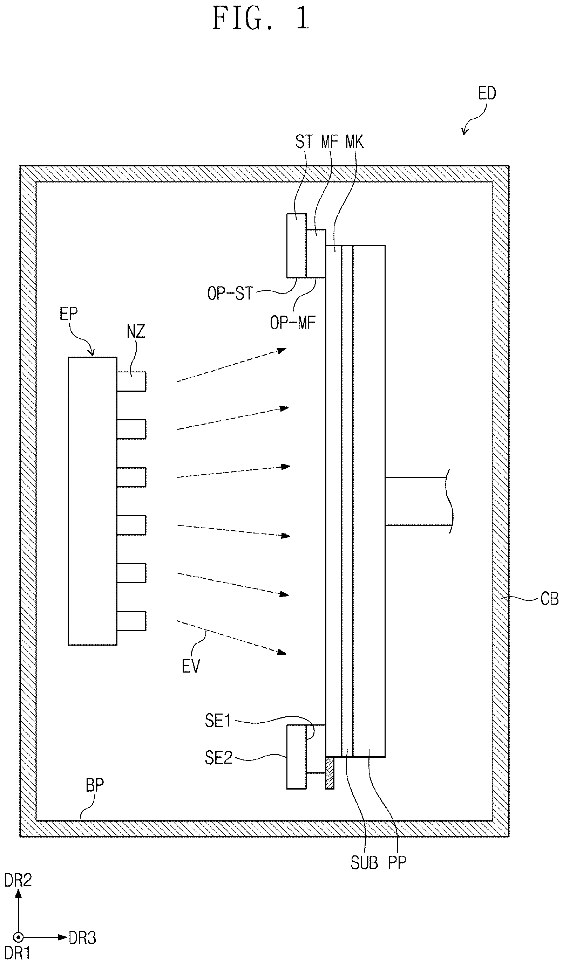

FIG. 1 is a schematic cross-sectional view of a deposition apparatus ED according to an embodiment.

Referring to FIG. 1, the deposition apparatus ED may include a chamber CB, a mask MK, a mask frame MF, a stage ST, a deposition source EP, and a fixing member PP. For example, the deposition apparatus ED may further include additional mechanical apparatuses to implement an inline system. The deposition apparatus ED may include a coupling member. The coupling member may be fixed to a sidewall of the chamber CB, and the stage ST may be connected to the coupling member and may be stably held in the chamber CB. Accordingly, even though the stage ST is vertically disposed, a deposition process may be stably performed.

The chamber CB may provide an inner space therein, and the deposition source EP, the mask MK, the mask frame MF, and the stage ST, in particular the mask assembly MSA, may be disposed in the inner space of the chamber CB. The chamber CB may form an enclosed space, and a deposition condition of the chamber CB may be set to a vacuum state. The chamber CB may include at least one gate and may be opened or closed by the gate. The mask MK, the mask frame MF, and a substrate SUB may enter and exit through the gate provided to the chamber CB.

The chamber CB may include a bottom surface BP, a ceiling surface, and sidewalls. The bottom surface BP of the chamber CB may be substantially parallel to a plane defined by a first direction DR1 and a third direction DR3. A normal line direction of the bottom surface BP of the chamber CB may be substantially parallel to a second direction DR2.

The fixing member PP may be disposed in the chamber CB and may face the deposition source EP in the third direction DR3. The fixing member PP may function the substrate SUB to be tightly adhered to the mask MK. The fixing member PP may include magnetic substances to attach the mask MK to the substrate SUB. As an example, the magnetic substances may generate a magnetic force to fix the mask MK, and thus, the substrate SUB disposed between the mask MK and the fixing member PP may be tightly adhered to the mask MK. However, embodiments are not limited thereto or thereby, and in another example, the fixing member PP may include a jig or a robot arm to hold the mask MK.

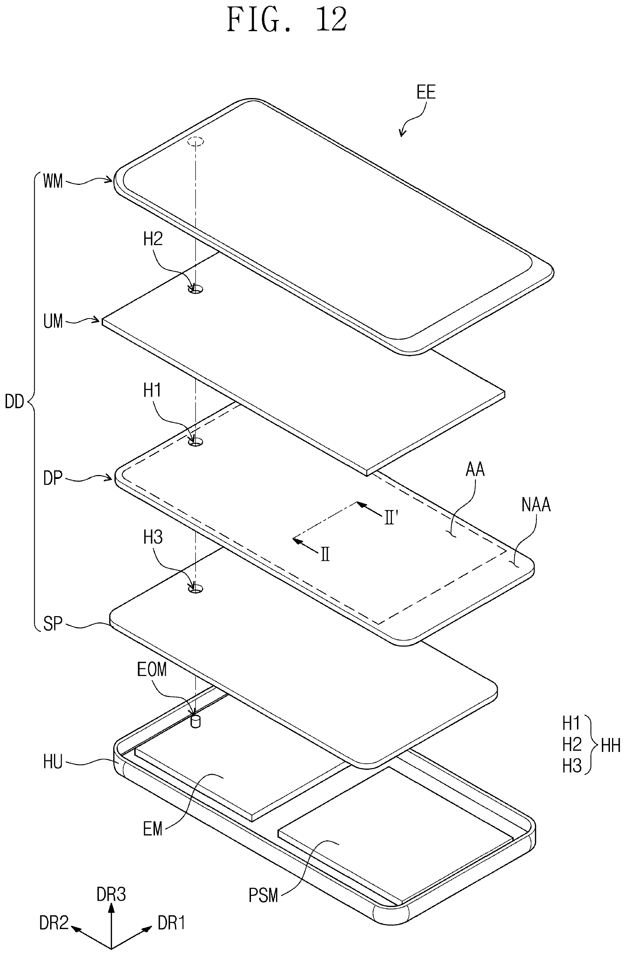

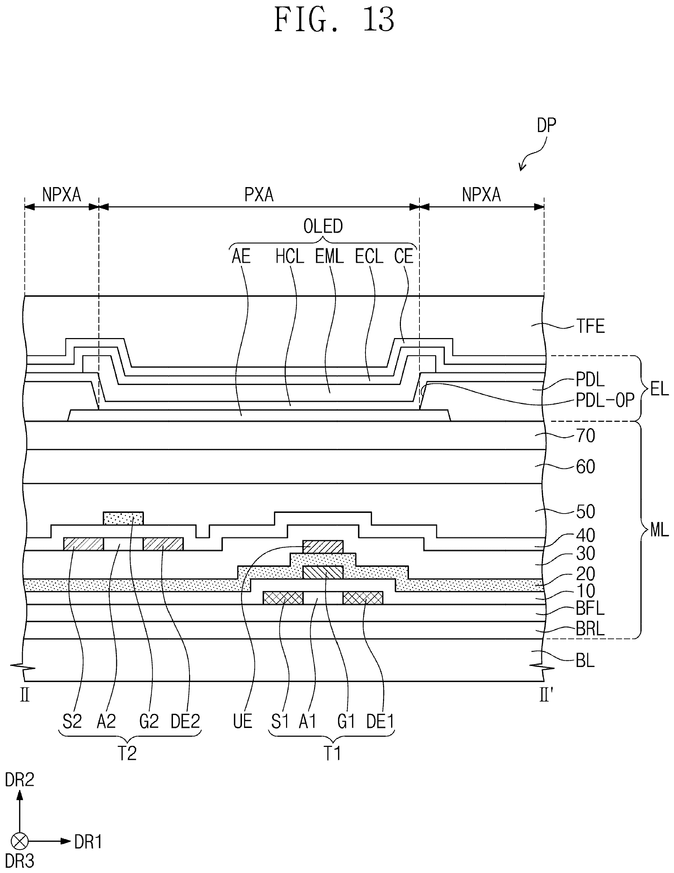

The substrate SUB may be disposed between the mask MK and the fixing member PP. The substrate SUB may be a process target on which a deposition material is deposited. The substrate SUB may include a support substrate and a synthetic resin layer disposed on the support substrate. The support substrate may be removed in a later stage of a manufacturing process of a display panel DP (refer to FIG. 12), and the synthetic resin layer may correspond to a base layer BL of FIG. 13. The substrate SUB may include some components of the display panel DP (refer to FIG. 12), which are formed on the base layer BL (refer to FIG. 13), according to components to be formed through the deposition process.

The deposition source EP may be disposed in the chamber CB to face the fixing member PP in the third direction DR3. The deposition source EP may include a space to accommodate the deposition material EV and at least one nozzle NZ. The deposition material EV may include an inorganic material, a metal material, or an organic material that is sublimable or vaporable. As an example, the deposition material EV may include an organic light emitting material to form a light emitting layer EML (refer to FIG. 12). The sublimated or vaporized deposition material EV may be sprayed to the substrate SUB through the nozzle NZ. The deposition material EV may be deposited and patterned on the substrate SUB after passing through mask openings OP-MK of the mask MK.

The stage ST may be disposed between the deposition source EP and the fixing member PP. The stage ST may support a rear surface of the mask frame MF and may be placed along the transport path (or ejection path) of the deposition material EV supplied from the deposition source EP to the substrate SUB. The stage ST may include (or be provided with) a stage opening OP-ST defined therethrough. The deposition material EV may be supplied to the mask MK through the stage opening OP-ST. Coupling grooves may be defined in corner portions of the stage ST to be coupled to the coupling member. The stage ST may be coupled to the coupling member through the coupling grooves by a bolt fastening method.

The stage ST may include a seating surface SE1 on which the mask frame MF is placed and a rear surface SE2 facing the seating surface SE1. Each of the seating surface SE1 and the rear surface SE2 of the stage ST may be a surface that is parallel to the first and second directions DR1 and DR2. As an example, the seating surface SE1 and the rear surface SE2 of the stage ST may be substantially perpendicular to the bottom surface BP of the chamber CB. Accordingly, the rear surfaces of the mask frame MF and the mask MK, which are sequentially disposed on the seating surface SE1 of the stage ST, may be substantially perpendicular to the bottom surface BP of the chamber CB, and the deposition process may be performed. Accordingly, the mask MK having a large area may be prevented from sagging (or bending) due to a gravity in a vertical deposition process, and a deposition reliability may be improved.

However, embodiments are not limited thereto or thereby. In another example, the seating surface SE1 and the rear surface SE2 of the stage ST may be substantially parallel to the bottom surface BP of the chamber CB, and the rear surfaces of the mask frame MF and the mask MK may be substantially parallel to the bottom surface BP of the chamber CB, and thus, a horizontal deposition process may be performed.

The mask frame MF may be coupled to the mask MK and may support the mask MK. The mask frame MF may include an upper surface facing the mask MK, a rear surface opposite to the upper surface and facing the seating surface SE1 of the stage ST, and side surfaces connecting the upper surface and the rear surface. The mask frame MF may have a rectangular frame shape. Accordingly, the mask frame MF may include (or be provided with) a frame opening OP-MF overlapping the stage opening OP-ST. The deposition material EV may be supplied to the mask MK through the frame opening OP-MF.

The mask frame MF may have a certain rigidity. As an example, the mask frame MF may include a metal material such as stainless steel (SUS), Invar, nickel (Ni), cobalt (Co), etc.

The mask MK may be disposed between the substrate SUB and the mask frame MF. The mask MK may include (or be provided with) the mask openings OP-MK defining a deposition area. The mask openings OP-MK may overlap the frame opening OP-MF. The deposition material EV may be deposited onto the substrate SUB through the mask openings OP-MK.

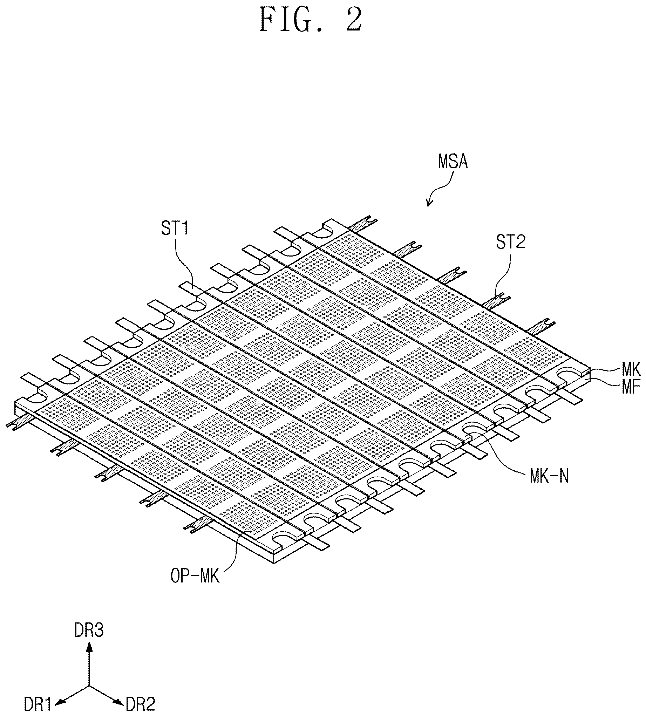

The mask MK may be provided in plural, and the masks MK may be disposed on the mask frame MF. FIG. 2 shows ten masks MK arranged in the first direction DR1, however, the shape and number of the masks MK should not be limited. Each of the masks MK may include Invar.

Each mask MK may have a longitudinal shape. The masks MK may be placed in parallel to each other. Each mask MK may have the same size and shape.

The masks MK may be coupled to the mask frame MF. As an example, the masks MK may be coupled to the mask frame MF by a welding process. As an example, ends (e.g., opposite ends) of each of the masks MK may be disposed on the mask frame MF, and the welding process may be performed on the ends (e.g., opposite ends) of the masks MK to couple the masks MK to the mask frame MF. Welding protrusions may be formed at the ends (e.g., opposite ends) of the masks MK by the welding process.

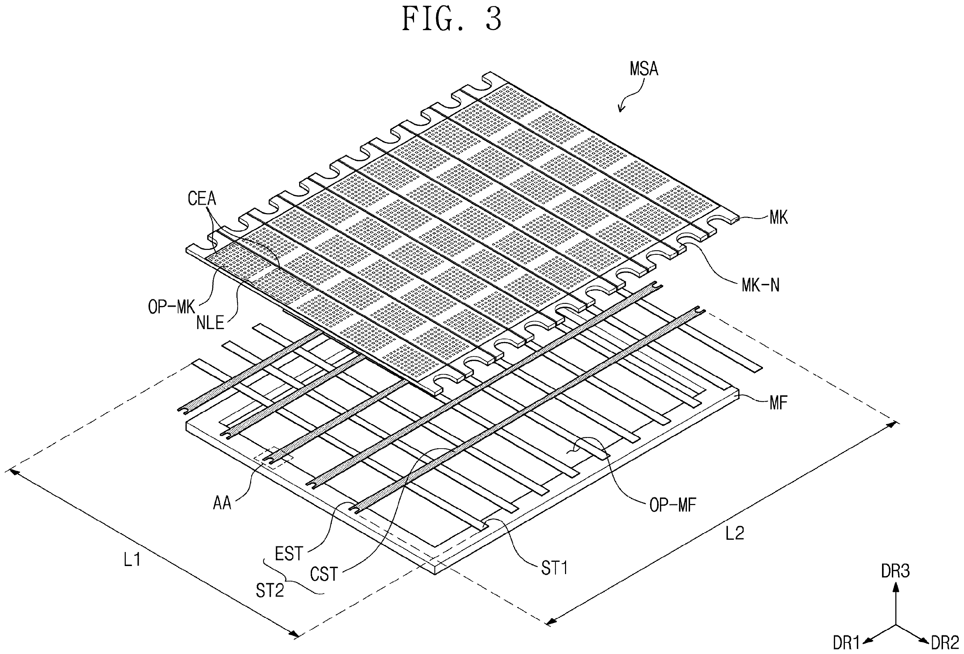

FIG. 2 is a schematic perspective view of a mask assembly MSA according to an embodiment, and FIG. 3 is an exploded schematic perspective view of the mask assembly MSA according to an embodiment.

Referring to FIGS. 2 and 3, the mask assembly MSA may include the mask frame MF, a first stick ST1, a second stick ST2, and the mask MK.

The frame opening OP-MF may be formed (or defined) through the mask frame MF. An inner side surface of the mask frame MF may define the frame opening OP-MF. The frame opening OP-MF may overlap the mask opening OP-MK of the mask MK.

The first stick ST1 may be disposed on the mask frame MF and may overlap the frame opening OP-MF. The first stick ST1 may be coupled to the mask frame MF by a welding process. The first stick ST1 may extend in the second direction DR2 and may cross the frame opening OP-MF. A center portion of the first stick ST1 may overlap the frame opening OP-MF, and an end portion of the first stick ST1 may not overlap the frame opening OP-MF. The first stick ST1 may not overlap the mask opening OP-MK. The first stick ST1 may not overlap an active area CEA of the mask MK. The first stick ST1 may extend in the second direction DR2 to have a first length L1. A plurality of first sticks ST1 may be placed in parallel to each other. The plurality of sticks ST1 may be placed spaced apart from each other, so that openings may remain between them.

The second stick ST2 may be disposed on the first stick ST1 and may overlap the frame opening OP-MF, an in particular the openings between the plurality of first sticks ST1. The second stick ST2 may be disposed to cross the first stick ST1, an in particular the openings between the plurality of first sticks ST1. The second stick ST2 may extend in the first direction DR1 intersecting the second direction DR2 and may cross the frame opening OP-MF. The second stick ST2 may not overlap the mask opening OP-MK. The second stick ST2 may not overlap the active area CEA of the mask MK. The second stick ST2 may extend in the first direction DR1 to have a second length L2 longer than the first length L1. For example, the second stick ST2 may be longer than the first stick ST1. The first stick ST1 may be referred to as a short side stick, and the second stick ST2 may be referred to as a long side stick.

The second stick ST2 may be disposed between the mask MK and the first stick ST1. The second stick ST2 may be disposed (e.g., directly disposed) on the first stick ST1. However, the arrangement relation between the first stick ST1 and the second stick ST2 should not be limited thereto or thereby, and in another example, the first stick ST1 may be disposed between the second stick ST2 and the mask MK. The first stick ST1 and the second stick ST2 may include a non-magnetic material. As an example, the first stick ST1 and the second stick ST2 may include aluminum. However, this is merely an example, and the material of the first stick ST1 and the second stick ST2 should not be limited thereto or thereby.

The second stick ST2 may include a first center portion CST and a first end portion EST. The first center portion CST may overlap the frame opening OP-MF, and the first end portion EST may not overlap the frame opening OP-MF. In other words, the first center portion CST may have a same length than the width of the frame opening OP-MF and the first end portion EST may be placed outside the frame opening OP-MF.

The first center portion CST may cross the frame opening OP-MF. The first center portion CST may have a width in the second direction DR2, which increases going from a center portion of the second stick ST2 toward the first end portion EST when viewed in the plane. The first center portion CST may have the smallest width in the second direction DR2 at the center portion thereof when viewed in the plane and may have the largest thickness in the second direction DR2 when viewed in the plane at a boundary between the first center portion CST and the first end portion EST.

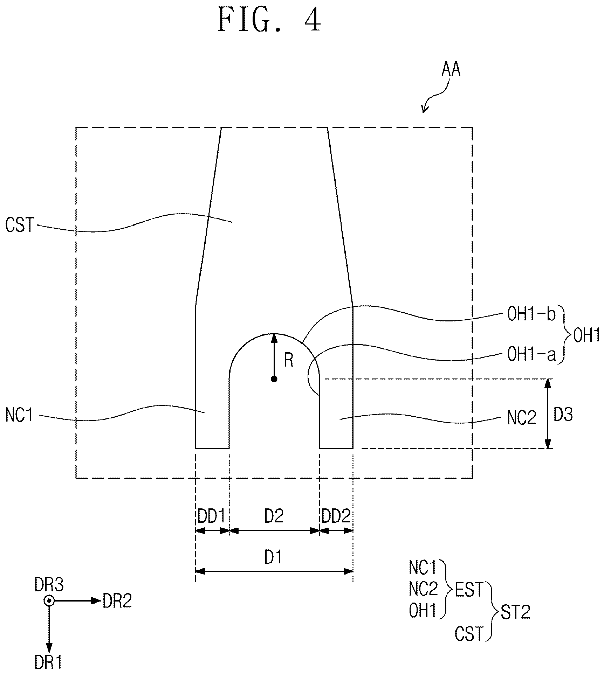

The first end portion EST may extend from the first center portion CST along the first direction DR1. The first end portion EST may be an end portion of the second stick ST2. The first end portion EST may have a notch shape. This will be described with reference to FIG. 4. The first stick ST1 and the second stick ST2 may function as a supporter to prevent the mask MK from being separated.

The mask MK may be disposed on the second stick ST2, and the mask opening OP-MK overlapping the frame opening OP-MF may be formed (or defined) through the mask MK. The mask MK may be a fine metal mask. The mask MK may include a magnetic material. As an example, the mask MK may include Invar. However, this is merely a representative example of the mask MK, and embodiments are not limited thereto or thereby.

The mask MK may include a plurality of active areas CEA and a non-active area NLE. The non-active area NLE may correspond to a portion of the mask MK except the active area CEA of the mask MK. The non-active area NLE may surround the active area CEA. The mask openings OP-MK may be formed (or defined) through the active area CEA. The active area CEA may not overlap the first stick ST1 and the second stick ST2. The non-active area NLE may not overlap the first stick ST1 and the second stick ST2.

A mask notch MK-N may be defined in the ends (e.g., opposite ends) of the mask MK in the second direction DR2. A concave portion may be formed in an outer side surface of the mask MK to be recessed toward a center portion of the mask MK. The concave portion may have a U-shape.

According to an embodiment, each of the mask MK, the first stick ST1, and the second stick ST2 may be provided in plural. The first sticks ST1 may be arranged spaced apart from each other in the first direction DR1. The second sticks ST2 may be spaced apart from each other in the second direction DR2. The masks MK may be arranged in the first direction DR1.

FIG. 4 is an enlarged schematic plan view of a portion of the second stick ST2 according to an embodiment.

Referring to FIG. 4, the second stick ST2 may include the first center portion CST and the first end portion EST protruding from the first center portion CST in the first direction DR1. The first end portion EST may include a first notch concave portion OH1, a first portion NC1, and a second portion NC2.

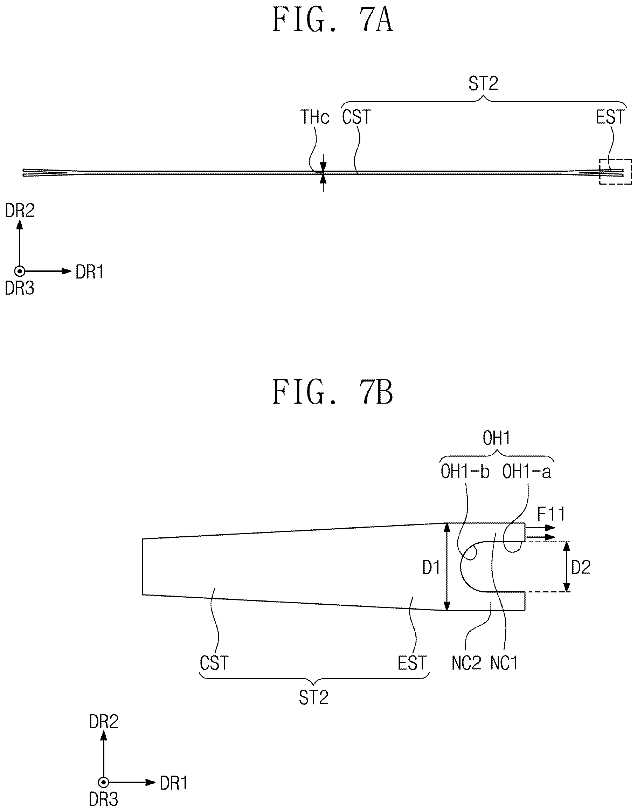

The first notch concave portion OH1 may be defined by recessing a center portion of an outer side surface of the first end portion EST toward the first center portion CST. The first notch concave portion OH1 may have a U-shape when viewed in the plane. A width D2 in the second direction DR2 of the first notch concave portion OH1 may be substantially equal to or greater than about 40% of a width D1 in the second direction DR2 of the first end portion EST, in particular when viewed in the plane. For example, an effect of correcting the bending of the second stick ST2 may increase. This will be described later with reference to FIGS. 7A to 7D.

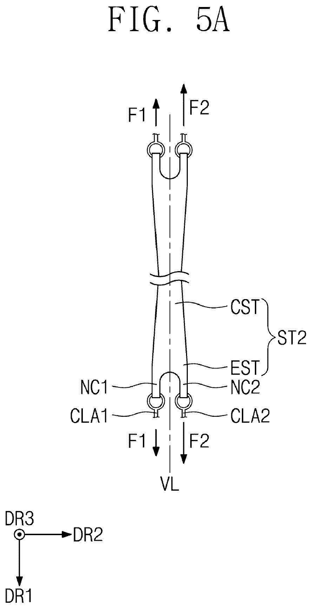

When viewed in the plane, the width D2 in the second direction DR2 of the first notch concave portion OH1 may be substantially equal to or smaller than about 80% of the width D1 in the second direction DR2 of the first end portion EST. In a case where the width D2 in the second direction DR2 of the first notch concave portion OH1 is greater than about 80% of the width D1 in the second direction DR2 of the first end portion EST, thicknesses DD1 and DD2 in the second direction DR2 of the first portion NC1 and the second portion NC2 may have a too small value. For example, in case that a first clamp CLA1 (refer to FIG. 5A) and a second clamp CLA2 (refer to FIG. 5A), which will be described later, apply a tensile force to the first portion NC1 and the second portion NC2, respectively, the first portion NC1 and the second portion NC2 may be damaged.

When viewed in the plane, the width D1 in the second direction DR2 of the first end portion EST may be substantially equal to or greater than about 25 mm. For example, the first end portion EST may be stably held by the first and second clamps CLA1 and CLA2 (refer to FIG. 5A).

The first notch concave portion OH1 may include a first-first notch concave portion OH1 -a having a substantially uniform width in the second direction DR2 when viewed in the plane and a first-second notch concave portion OH1-b having a width in the second direction DR2 that decreases as a distance from the first center portion CST decreases (as being closer to the first center portion CST). The first-first notch concave portion OH1-a may extend in the first direction DR1. The first-second notch concave portion OH1 -b may be a curved line having a substantially uniform curvature (e.g., radius of curvature R) when viewed in the plane. The curvature of the first-second notch concave portion OH1-b may be about 0.5 times the width D2 (i.e., a maximum width) in the second direction DR2 of the first notch concave portion OH1 when viewed in the plane. For example, in case that the first-second notch concave portion OH1-b forms the substantially uniform curvature and a tensile force described later is applied to the first portion NC1 and the second portion NC2, the applied tensile force may be substantially uniformly distributed over the first end portion EST.

The first portion NC1 and the second portion NC2 may protrude from the first center portion CST in a direction toward the outside, i.e., the first direction DR1. The first portion NC1 and the second portion NC2 may have a rectangular shape when viewed in the plane. The first notch concave portion OH1 may be disposed between the first portion NC1 and the second portion NC2. The first portion NC1 may be disposed at a left side of the first notch concave portion OH1, and the second portion NC2 may be disposed at a right side of the first notch concave portion OH1. When viewed in the plane, a right side surface of the first portion NC1 and a left side surface of the second portion NC2 may form the first-first notch concave portion OH1-a. When viewed in the plane, the curved line connecting the right side surface of the first portion NC1 and the left side surface of the second portion NC2 may form the first-second notch concave portion OH1-b.

When viewed in the plane, the thickness DD1 in the second direction DR2 of the first portion NC1 may be substantially uniform in the first direction DR1. When viewed in the plane, the thickness DD2 in the second direction DR2 of the second portion NC2 may be substantially uniform in the first direction DR1. Accordingly, the first clamp CLA1 (refer to FIG. 5A) and the second clamp CLA2 (refer to FIG. 5A) may stably hold the first portion NC1 and the second portion NC2, respectively.

When viewed in the plane, the thickness DD1 in the second direction DR2 of the first portion NC1 and the thickness DD2 in the second direction DR2 of the second portion NC2 may be substantially the same as each other. Accordingly, the thickness in the second direction DR2 of one of the first portion NC1 and the second portion NC2 may be prevented from being too small and the first portion NC1 and the second portion NC2 may be prevented from being damaged due to the tensile force applied thereto by the first and second clamps CLA1 and CLA2 (refer to FIG. 5A).

When viewed in the plane, a length D3 in the first direction DR1 of the first-first notch concave portion OH1-a may be substantially equal to or greater than about 8 mm and substantially equal to or smaller than about 12 mm. For example, the length D3 in the first direction DR1 of the first-first notch concave portion OH1-a and a length in the first direction DR1 of the first portion NC1 and the second portion NC2 may be substantially the same as each other. When viewed in the plane, in a case where the length D3 in the first direction DR1 of the first-first notch concave portion OH1-a is smaller than about 8 mm, it may be difficult for the first and second clamps CLA1 and CLA2 (refer to FIG. 5A) described later to hold the first portion NC1 and the second portion NC2, respectively. When viewed in the plane, in a case where the length D3 in the first direction DR1 of the first-first notch concave portion OH1-a is greater than about 12 mm, the first portion NC1 and the second portion NC2 may become too long, and the first portion NC1 and the second portion NC2 may be damaged due to the bending deformation caused by the tensile force applied to the first portion NC1 and the second portion NC2. When viewed in the plane, the length D3 in the first direction DR1 of the first-first notch concave portion OH1-a may be about 10 mm.

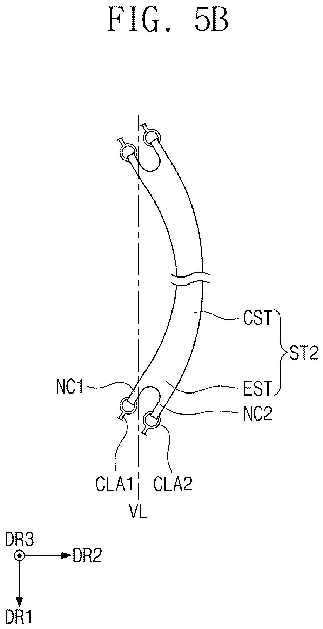

FIG. 5A is a plan view of the second stick ST2 before being bent according to an embodiment, and FIG. 5B is a plan view of the second stick ST2 after being bent according to an embodiment.

Referring to FIG. 5A, the first portion NC1 of the first end portion EST may be held by the first clamp CLA1. The second portion NC2 of the first end portion EST may be held by the second clamp CLA2. A virtual vertical line VL may be a virtual vertical line passing through a center portion of the second stick ST2 before the second stick ST2 is bent. A first tensile force F1 may be applied to the first portion NC1 held by the first clamp CLA1 in the first direction DR1 and a direction opposite to the first direction DR1. A second tensile force F2 may be applied to the second portion NC2 held by the second clamp CLA2 in the first direction DR1 and the direction opposite to the first direction DR1. The second tensile force F2 may be greater than the first tensile force F1.

As described above, the degree of the bending deformation of the second stick ST2 may be controlled by applying the tensile forces of different magnitudes to the first portion NC1 and the second portion NC2. FIG. 5A shows the second stick ST2 in the case where the second tensile force F2 is greater than the first tensile force F1 as a representative example, however, the magnitude of the second tensile force F2 and the magnitude of the first tensile force F1 may vary according to the degree of the bending of the second stick ST2. As an example, the first tensile force F 1 may be greater than the second tensile force F2, or the first tensile force F1 and the second tensile force F2 may be substantially the same as each other. For example, only the second tensile force F2 may be applied to the second portion NC2 in case that the first tensile force F1 is not applied to the first portion NC1, or only the first tensile force F1 may be applied to the first portion NC1 in case that the second tensile force F2 is not applied to the second portion NC2.

Referring to FIG. 5B, the bending deformation may occur in the second stick ST2 by the tensile force applied to the first portion NC1 and the second portion NC2. Since the second tensile force F2 (refer to FIG. 5A) applied to the second portion NC2 is greater than the first tensile force F1 (refer to FIG. 5A) applied to the first portion NC1, the second stick ST2 may be bent in the second direction DR2. The center portion of the second stick ST2 may be positioned to the right in the second direction DR2 compared with the center portion of the second stick ST2 at which the virtual vertical line VL passes before the second stick ST2 is bent.

FIG. 5B shows the case where the second tensile force F2 (refer to FIG. 5A) is greater than the first tensile force F1 (refer to FIG. 5A). In a case where the second tensile force F2 (refer to FIG. 5A) is smaller than the first tensile force F1 (refer to FIG. 5A), the second stick ST2 may be bent toward a direction opposite to the second direction DR2. For example, the center portion of the second stick ST2 may be positioned to the left in the direction opposite to the second direction DR2 compared with the center portion of the second stick ST2 at which the virtual vertical line VL passes before the second stick ST2 is bent. As described above, the degree of the bending of the second stick ST2 may be adjusted based on the difference between the first tensile force F1 (refer to FIG. 5A) and the second tensile force F2 (refer to FIG. 5A).

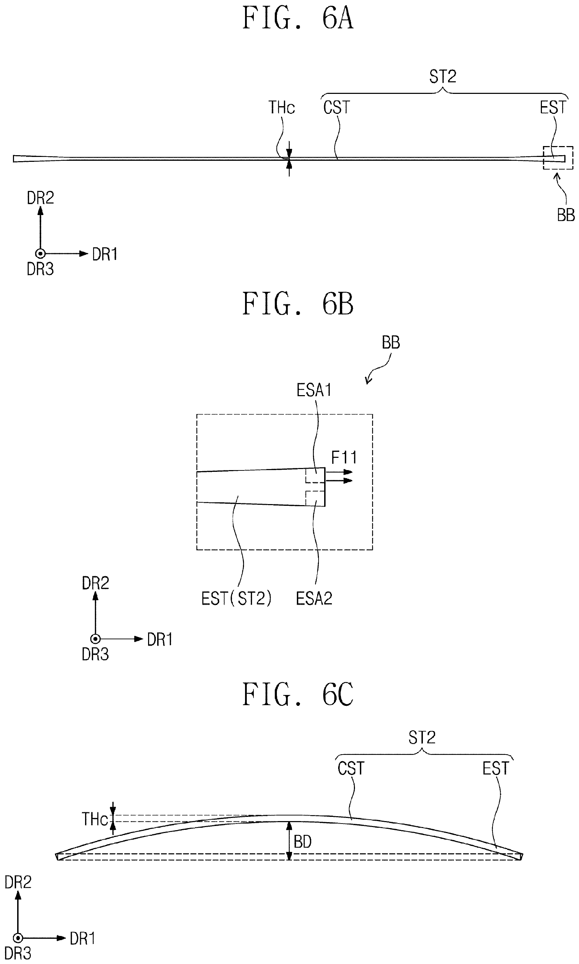

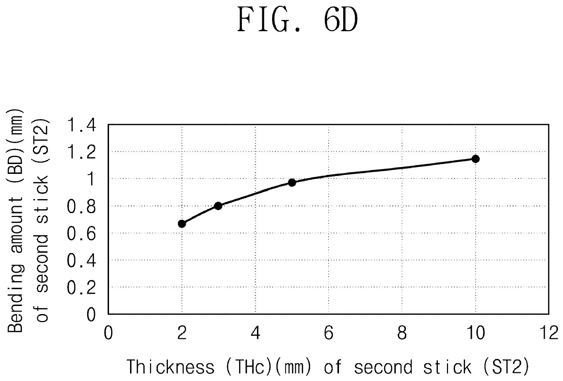

FIG. 6A is a plan view of a second stick ST2 in which a notch concave portion is not defined. FIG. 6B is a plan view of the second stick ST2 in which the notch concave portion is not defined and to which a differential tensile force is applied. FIG. 6C is a plan view of the second stick ST2 after being bent. FIG. 6D is a graph illustrating a degree of bending of the second stick ST2 as a function of a width of the second stick ST2 of 6B.

In more detail, results of simulating the bending deformation of the second stick ST2 under conditions of FIGS. 6A to 6C are shown in FIG. 6D.

Referring to FIG. 6A, the second stick ST2 of FIG. 6 is different from the second stick ST2 of FIG. 5A in that the first notch concave portion OH1 (refer to FIG. 4) may not be defined in the second stick ST2. Referring to FIG. 6B, a first end portion EST may include a first area ESA1 and a second area ESA2. The first area ESA1 and the second area ESA2 may be held by a clamp. For example, a tensile force F11 may be applied only to the first area ESA1. The tensile force F11 may be about 9,8 N (10 kgf). Referring to FIG. 6C, the second stick ST2 may be bent in the second direction DR2 due to the tensile force F11 (refer to FIG. 6B) applied only to the first area ESA1. For example, a maximum displacement (or maximum bending amount) BD may occur at a center portion of a first center portion CST in the second direction DR2.

FIG. 6D shows a variation of the maximum displacement (or maximum bending amount) BD (refer to FIG. 6C) in the second direction DR2 (refer to FIG. 6C) of the second stick ST2 (hereinafter, referred to as a bending amount BD of the second stick ST2) according to a variation in a minimum thickness THc in the second direction DR2 (refer to FIG. 6C) of the second stick ST2 (hereinafter, referred to as a thickness THc of the second stick ST2). In a case where the thickness THc of the second stick ST2 is about 10 mm, the bending amount BD of the second stick ST2 may be about 1.15 mm. In a case where the thickness THc of the second stick ST2 is about 5 mm, the bending amount BD of the second stick ST2 may be about 1 mm. In a case where the thickness THc of the second stick ST2 is about 3 mm, the bending amount BD of the second stick ST2 may be about 0.8 mm. In a case where the thickness THc of the second stick ST2 is about 2 mm, the bending amount BD of the second stick ST2 may be about 0.7 mm.

In case that the same differential tensile force F11 (refer to FIG. 6B) is applied, the bending amount BD of the second stick ST2 decreases as the thickness THc of the second stick ST2 decreases. Accordingly, in the case where the thickness THc of the second stick ST2 decreases, higher differential tensile force F11 (refer to FIG. 6B) may be required to achieve a required bending amount BD of the second stick ST2.

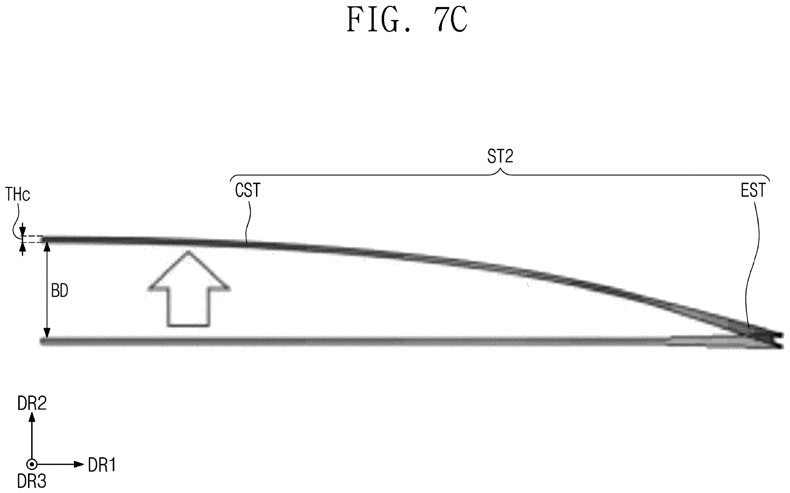

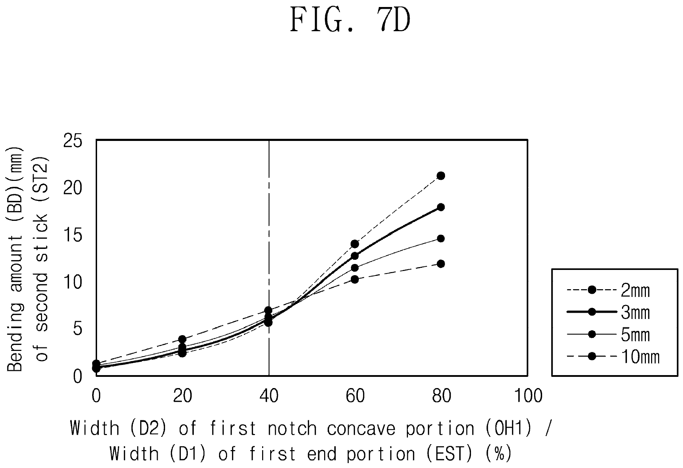

FIG. 7A is a plan view of the second stick ST2 according to an embodiment. FIG. 7B is a plan view of the second stick ST2 to which the differential tensile force is applied according to an embodiment. FIG. 7C is a plan view of the second stick ST2 before and after being bent according to an embodiment. FIG. 7D is a graph illustrating the degree of bending of the second stick as a function of a ratio of a width of the first notch concave portion to a width of the first end portion in case that the width of the second stick ST2 of FIG. 7B is changed according to an embodiment.

In more detail, results of simulating the bending deformation of the second stick ST2 under conditions of FIGS. 7A and 7B are shown in FIGS. 7C and 7D. Hereinafter, in FIGS. 7A to 7C, the same reference numerals denote the same elements in FIGS. 1 to 5B, and thus, detailed descriptions of the same elements will be omitted for descriptive convenience.

Referring to FIG. 7A, the first end portion EST of the second stick ST2 may have the notch shape. Referring to FIG. 7B, the first portion NC1 and the second portion NC2 may be held by the clamp. The tensile force F11 may be applied only to the first portion NC1. The tensile force F11 may be about 9,8 N (10 kgf). The width D1 in the second direction DR2 of the first end portion EST may be about 25 mm. Referring to FIG. 7C, the second stick ST2 may be bent toward the second direction DR2 due to the tensile force F11 (refer to FIG. 7B) applied only to the first portion NC1. For example, the maximum displacement (or maximum bending amount) BD may occur at the center portion of the first center portion CST in the second direction DR2. The minimum thickness THc of the first center portion CST may be substantially equal to or smaller than about 5 mm.

FIG. 7D shows graphs in case that the minimum thickness THc (refer to FIG. 7C) in the second direction DR2 of the second stick ST2 (hereinafter, referred to as the thickness THc of the second stick ST2) is about 2 mm, about 3 mm, about 5 mm, and about 10 mm. The graphs shown in FIG. 7D show the maximum displacement (or maximum bending amount) BD (refer to FIG. 7C) in the second direction DR2 of the second stick ST2 (hereinafter, referred to as the bending amount BD of the second stick ST2) according to a ratio (hereinafter, referred to as a notch ratio) of the width D2 in the second direction DR2 of the first notch concave portion OH1 (refer to FIG. 7B) to the width D1 in the second direction DR2 of the first end portion EST.

As comparing the graph of FIG. 6D with the graphs of FIG. 7D, it is observed that the bending amount BD of the second stick ST2 is large in the case where the first notch concave portion OH1 (refer to FIG. 7C) is defined in the first end portion EST (refer to FIG. 7B) as shown in FIG. 7D. FIG. 6D is the graph showing the bending amount BD of the second stick ST2 in case that the notch ratio is 0%. Referring to FIG. 6D, in the case where the thickness THc of the second stick ST2 is about 5 mm, the bending amount BD of the second stick ST2 is about 1 mm. Referring to FIG. 7D, in the case where the thickness THc of the second stick ST2 is about 5 mm and the notch ratio is about 60%, the bending amount BD of the second stick ST2 is about 11 mm. For example, in the case where only the notch ratio is changed from 0% of FIG. 6D to 60% of FIG. 7D, the bending amount BD of the second stick ST2 may increase from about 1 mm to about 11 mm in case that the same tensile force of about 9,8 N (10 kgf) is applied to the second stick ST2 of FIG. 6A and the second stick ST2 of FIG. 7A.

Referring to FIGS. 7C and 7D, in case that the thickness THc of the second stick ST2 is about 2 mm, about 3 mm, or about 5 mm and the notch ratio is larger than about 40%, the bending amount BD of the second stick ST2 may increase drastically. In case that the thickness THc of the second stick ST2 is about 10 mm, a degree of increase of the bending amount BD of the second stick ST2 according to the increase of the notch ratio is not drastic compared with in case that the thickness THc of the second stick ST2 is about 2 mm, about 3 mm, or about 5 mm. In the case where the thickness THc of the second stick ST2 is substantially equal to or smaller than about 5 mm and the notch ratio is substantially equal to or greater than about 40%, the bending amount BD of the second stick ST2 may increase in case that the same differential tensile force of about 9,8 N (10 kgf) is applied.

In the case where the notch ratio is smaller than about 40%, as the thickness THc of the second stick ST2 increases, the bending amount BD of second stick ST2 may tend to increase. In case that the notch ratio is substantially equal to or greater than about 40%, as the thickness THc of the second stick ST2 decreases, the bending amount BD of second stick ST2 may tend to increase. Accordingly, in case that it is necessary to reduce the thickness THc of the second stick ST2, the notch ratio of about 40% or higher may be appropriate to increase the bending amount BD of the second stick ST2.

As shown by the graph of FIG. 6D, in case that the thickness THc of the second stick ST2 decreases, the bending amount BD of the second stick ST2 decreases. As shown by the graphs of FIG. 7D, in the case where the notch ratio is substantially equal to or greater than about 40%, as the thickness THc of the second stick ST2 decreases, a degree of increase of the bending amount BD of the second stick ST2 may increase. Accordingly, in case that it is necessary to reduce the thickness THc of the second stick ST2, the notch ratio of about 40% or higher may be appropriate to increase the bending amount BD of the second stick ST2, and thus, the effect of correcting the bending of the second stick ST2 may increase.

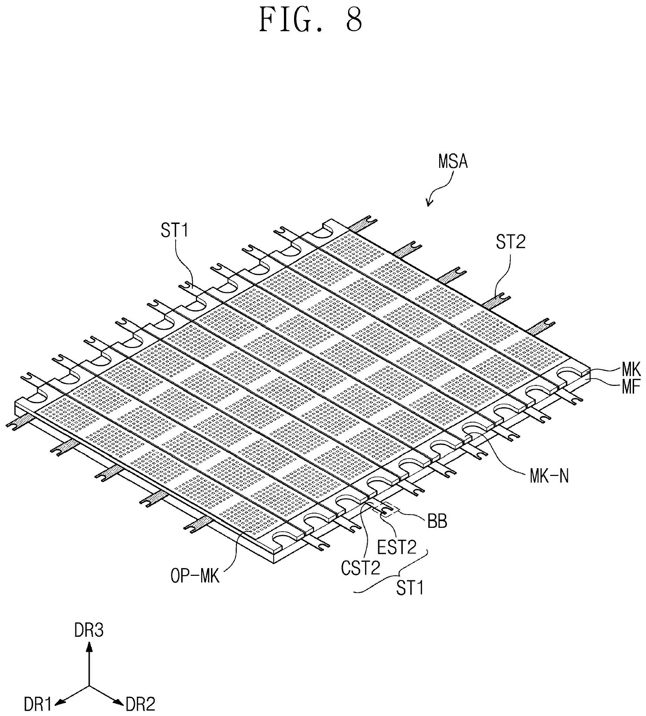

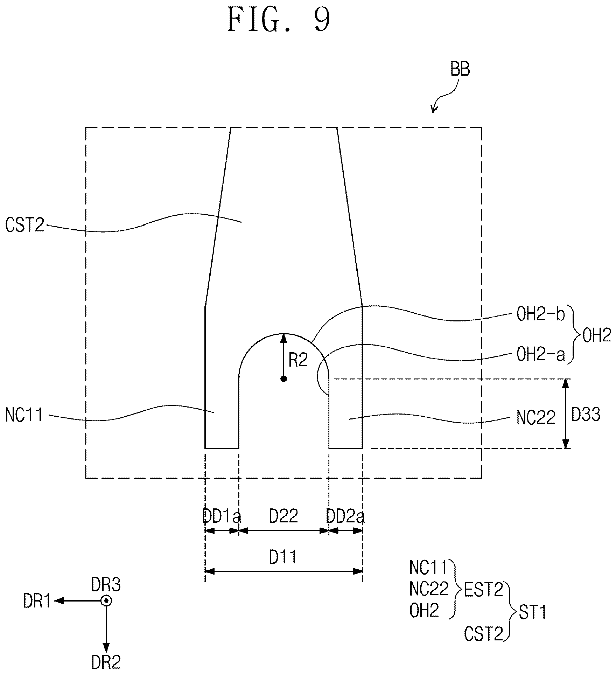

FIG. 8 is a schematic perspective view of a mask assembly MSA according to an embodiment. FIG. 9 is an enlarged schematic plan view of a portion of a first stick according to an embodiment. In more detail, FIG. 9 is an enlarged schematic plan view of an area BB of FIG. 8. The mask assembly MSA shown in FIG. 8 has substantially the same structure and function as those of the mask assembly MSA of FIG. 2 except a second end portion EST2 of the first stick ST1, and thus, details of the same elements will be omitted for descriptive convenience.

Referring to FIGS. 8 and 9, the first stick ST1 may have substantially the same structure as a second stick ST2. For example, the first stick ST1 may include a second center portion CST2 crossing the frame opening OP-MF (refer to FIG. 3) and extending in the second direction DR2 and the second end portion EST2 extending from the second center portion CST2 in the second direction DR2. The second end portion EST2 may have a notch shape.

A second notch concave portion OH2 may be defined by recessing a center portion of an outer side surface of the second end portion EST2 toward the second center portion CST2. The second notch concave portion OH2 may have a U-shape. When viewed in the plane, a width D22 in the first direction DR1 of the second notch concave portion OH2 may be substantially equal to or greater than about 40% of a width D11 in the first direction DR1 of the second end portion EST2.

When viewed in the plane, the width D22 in the first direction DR1 of the second notch concave portion OH2 may be substantially equal to or smaller than about 80% of the width D11 in the first direction DR1 of the second end portion EST2. When viewed in the plane, the width D11 in the first direction DR1 of the second end portion EST2 may be substantially equal to or greater than about 25 mm.

The second notch concave portion OH2 may include a second-first notch concave portion OH2-a having a substantially uniform width in the first direction DR1 when viewed in the plane and a second-second notch concave portion OH2-b having a width in the first direction DR1 that decreases as a distance from the second center portion CST2 decreases. The second-second notch concave portion OH2-b may be a curved line having a substantially uniform curvature (e.g., radius of curvature R2) when viewed in the plane. The curvature of the second-second notch concave portion OH2-b may be about 0.5 times a maximum width D22 in the first direction DR1 of the second notch concave portion OH2 when viewed in the plane.

A third portion NC11 and a fourth portion NC22 may protrude from the second center portion CST2 in the second direction DR2 toward the outside. The second notch concave portion OH2 may be disposed between the third portion NC11 and the fourth portion NC22.

When viewed in the plane, a thickness DD1a in the first direction DR1 of the third portion NC11 may be substantially uniform in the second direction DR2. When viewed in the plane, a thickness DD2a in the first direction DR1 of the fourth portion NC22 may be substantially uniform in the second direction DR2. When viewed in the plane, the thickness DD1a in the first direction DR1 of the third portion NC11 and the thickness DD2a in the first direction DR1 of the fourth portion NC22 may be substantially the same as each other.

When viewed in the plane, a length D33 in the second direction DR2 of the second-first notch concave portion OH2-a may be substantially equal to or greater than about 8 mm and substantially equal to or smaller than about 12 mm. When viewed in the plane, the length D33 in the second direction DR2 of the second-first notch concave portion OH2-a may be about 10 mm.

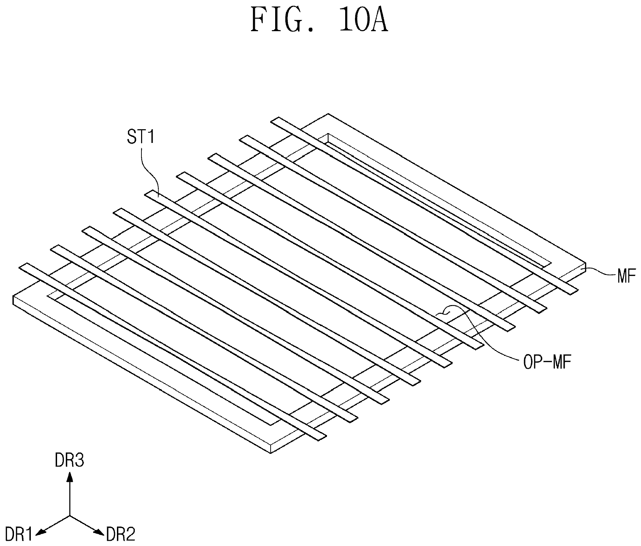

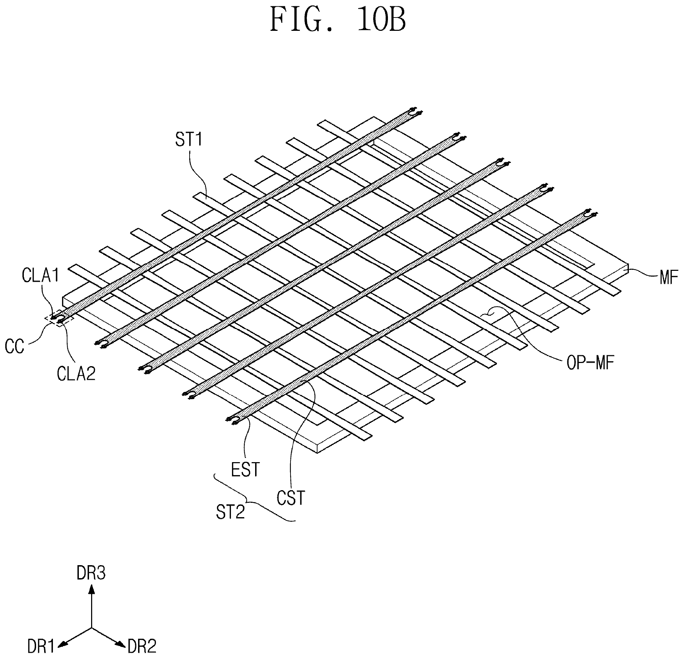

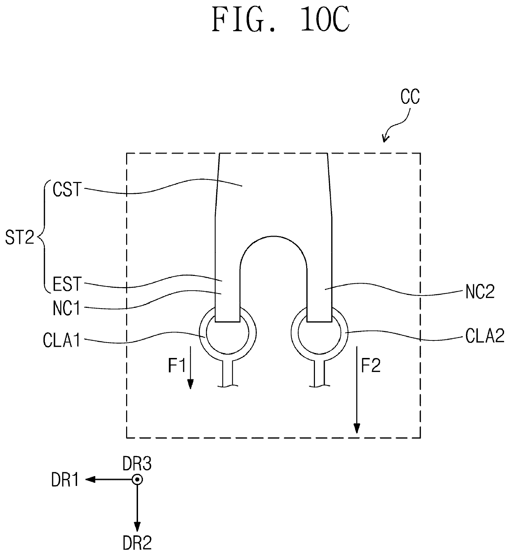

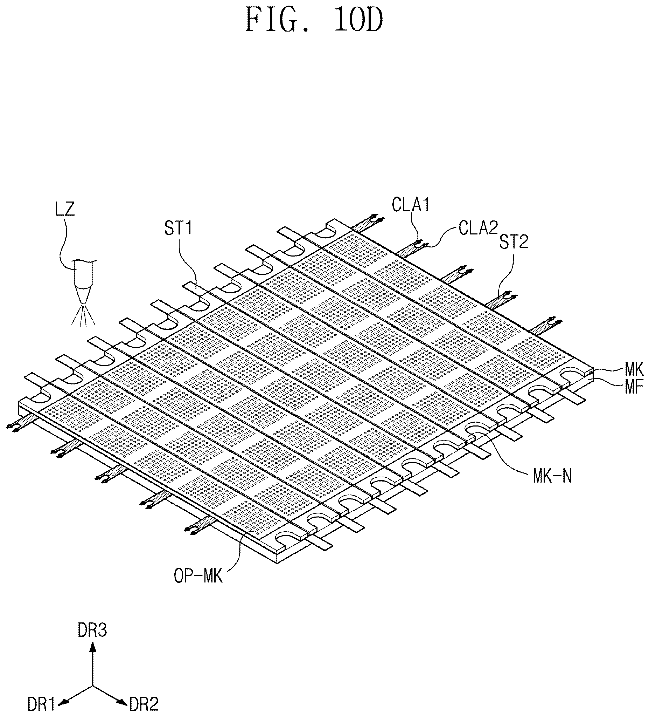

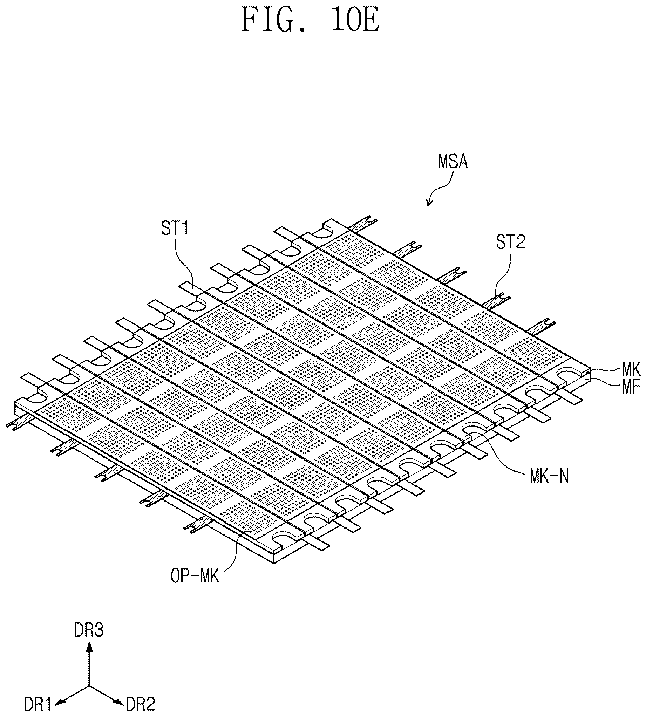

FIGS. 10A, 10B, 10C, 10D, and 10E are schematic views illustrating a method of manufacturing the mask assembly according to an embodiment. In FIGS. 10A, 10B, 10C, 10D, and 10E, the same reference numerals denote the same elements in FIGS. 1 to 5B, and thus, detailed descriptions of the same elements will be omitted for descriptive convenience.

Referring to FIG. 10A, the first stick ST1 extending in the second direction DR2 may be disposed on the mask frame MF through which the frame opening OP-MF is defined. The first sticks ST1 may be arranged in the first direction DR1 and may be spaced apart from each other in the first direction DR1. The first stick ST1 may overlap the frame opening OP-MF and may cross the frame opening OP-MF.

FIG. 10C is an enlarged schematic plan view of an area CC of FIG. 10B. Referring to FIGS. 10B and 10C, the second stick ST2 may be disposed on the first stick ST1. The second stick ST2 may extend in the first direction DR1 intersecting the second direction DR2. The second sticks ST2 may be arranged in the second direction DR2 and may be spaced apart from each other in the second direction DR2. The second stick ST2 may overlap the frame opening OP-MF and may cross the frame opening OP-MF.

For example, the first portion NC1 of the first end portion EST may be held by the first clamp CLA1, the second portion NC2 of the first end portion EST is held by the second clamp CLA2, and the tensile force may be applied. FIG. 10C shows the case in which the second tensile force F2 applied to the second portion NC2 by the second clamp CLA2 is greater than the first tensile force F1 applied to the first portion NC1 by the first clamp CLA1, however, this is merely an example. According to an embodiment, the first tensile force F1 may be greater than the second tensile force F2, and one of the first tensile force F1 and the second tensile force F2 may be zero (0). The degree of the bending deformation of the second stick ST2 may be controlled by adjusting the first tensile force F1 and the second tensile force F2 respectively applied to the first portion NC1 and the second portion NC2.

Referring to FIGS. 10D and 10E, the mask MK including the mask opening OP-MK overlapping the frame opening OP-MF, may be disposed on the second stick ST2. The mask frame MF may be bonded to the mask MK by a laser unit LZ. As an example, in the case where a welding process is used to bond the mask frame MF to the mask MK, the bonded portion of the mask frame MF and mask MK may include a metal material with high rigidity. After the mask frame MF is bonded to the mask MK, the first clamp CLA1 and the second clamp CLA2 may be removed. The first clamp CLA1 and the second clamp CLA2 may prevent the second stick ST2 from moving in the welding process.

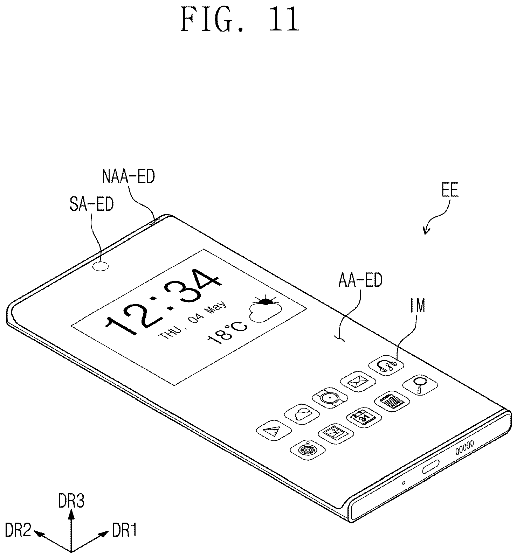

FIG. 11 is a schematic perspective view of an electronic device EE according to an embodiment. FIG. 12 is an exploded schematic perspective view of the electronic device EE according to an embodiment. FIG. 13 is a schematic cross-sectional view of the display panel DP according to an embodiment. The above-described mask assembly MSA (refer to FIG. 3) may be used to form at least a portion of functional layers included in the electronic device EE.

Referring to FIGS. 11 and 12, the electronic device EE may be a device that is activated in response to electrical signals. The electronic device EE may include a mobile phone, a tablet computer, a car navigation unit, a game unit, or a wearable device, however, embodiments are not limited thereto or thereby. FIG. 11 shows the mobile phone as a representative example of the electronic device EE including the display panel DP.

The electronic device EE may display an image IM through an active area AA-ED. The active area AA-ED may include a plane defined by the first direction DR1 and the second direction DR2. The active area AA-ED may further include a curved surface bent from at least one side of the plane defined by the first direction DR1 and the second direction DR2. The electronic device EE shown in FIG. 11 may include two curved surfaces respectively bent from both of opposite sides of the plane defined by the first direction DR1 and the second direction DR2. However, the shape of the active area AA-ED should not be limited thereto or thereby. For example, the active area AA-ED may include only the plane (or flat area), or the active area AA-ED may include curved surfaces respectively bent from at least two or more sides of the plane, e.g., four curved surfaces respectively bent from four sides of the plane.

The electronic device EE may include a sensing area SA-ED defined therein. FIG. 11 shows one sensing area SA-ED, however, the number of the sensing areas SA-ED should not be limited thereto or thereby, and two or more sensing areas SA-ED may be defined. For example, the sensing area SA-ED may be defined in the active area AA-ED and may be a portion of the active area AA-ED.

The electronic device EE may include the active area AA-ED and a peripheral area NAA-ED adjacent to the active area AA-ED. The active area AA-ED may correspond to a display area AA of the display panel DP, and the peripheral area NAA-ED may correspond to a non-display area NAA of the display panel DP.

The peripheral area NAA-ED may be an area to block an optical signal and may be disposed outside the active area AA-ED to surround the active area AA-ED. According to an embodiment, the peripheral area NAA-ED may be defined in a side surface of the electronic device EE rather than a front surface of the electronic device EE. The electronic device EE may include at least one side surface that is bent, and the peripheral area NAA-ED may be defined in the bent side surface.

The electronic device EE may include a display device DD, a housing HU, and an electro-optical module EOM. The display device DD may include a window WM, an upper member UM, the display panel DP, and a lower member SP.

The display device DD may include the window WM disposed on the display panel DP. The window WM may provide an exterior of the electronic device EE. The window WM may cover a front surface of the display panel DP and may protect the display panel DP from external impacts and scratches. The window WM may be attached to the upper member UM by an adhesive layer.

The window WM may include an optically transparent insulating material. As an example, the window WM may include a cover glass or a synthetic resin film as its cover member. The window WM may have a single-layer structure or a multi-layer structure. For example, the window WM may have a single-layer structure of a cover glass, may have a structure in which a plurality of plastic films is coupled to each other by an adhesive, or may have a structure in which a cover glass and a plastic film are coupled to each other by an adhesive. The window WM may further include a functional layer, such as an anti-fingerprint layer, a phase control layer, a hard coating layer, etc., disposed on a transparent base.

In the display device DD, the upper member UM may be disposed under the window WM and on the display panel DP. The upper member UM may include an anti-reflective layer and an input sensing sensor. The anti-reflective layer may reduce a reflectance of the display device DD with respect to an external light. The input sensing sensor may sense an external input generated by a user. The upper member UM may further include an adhesive layer to attach the anti-reflective layer to the input sensing sensor.

In the display device DD, the display panel DP may be disposed under the upper member UM. The lower member SP may be disposed under the display panel DP.

The display panel DP may include the display area AA through which the image IM is displayed and the non-display area NAA adjacent to the display area AA. For example, the front surface of the display panel DP may include the display area AA and the non-display area NAA. The display area AA may be activated in response to electrical signals and may be an area in which the image IM displayed through the active area AA-ED of the electronic device EE is generated.

The non-display area NAA may be defined adjacent to the display area AA. The non-display area NAA may surround the display area AA. A driving circuit or a driving line to drive the display area AA, various signal lines or pads to provide electrical signals to the display area AA, or electronic elements may be arranged in the non-display area NAA.

The electronic device EE may include (or be provided with) a through hole HH formed (or defined) through at least one of components included therein. The through hole HH may be formed (or defined) through, for example, each of the display panel DP, the upper member UM, and the lower member SP.

A first panel hole H1 may be formed (or defined) in the display area AA of the display panel DP. The first panel hole H1 may be formed (or defined) to overlap the sensing area SA-ED of the electronic device EE that includes the display panel DP. The first panel hole H1 may be formed (or defined) through a portion of the display panel DP, which overlaps the sensing area SA-ED of the electronic device EE. For example, the first panel hole H1 may be formed to have a shape penetrating the display panel DP from an upper surface to a lower surface of the display panel DP, however, embodiments are not limited thereto or thereby. In another example, one or more components of the display panel DP may not be penetrated in the portion where the first panel hole H1 is defined. As an example, the base layer BL (refer to FIG. 13) of the display panel DP may not be penetrated in the portion where the first panel hole H1 is defined. The electro-optical module EOM may be disposed to correspond to (or to overlap) the portion where the first panel hole H1 is defined.

A second panel hole H2 may be formed (or defined) through the upper member UM to correspond to the first panel hole H1 of the display panel DP. The second panel hole H2 may be formed (or defined) to overlap the sensing area SA-ED of the electronic device EE. FIG. 12 shows a structure in which the second panel hole H2 has substantially the same shape and size as those of the first panel hole H1 as a representative example, however, embodiments are not limited thereto or thereby. In another example, the shape and size of the second panel hole H2 may be different from those of the first panel hole H1.

The lower member SP may be disposed under the display panel DP. The lower member SP may support the display panel DP, may absorb impacts applied to the display panel DP, and may dissipate heat generated from components disposed under the display panel DP, e.g., an electronic module EM and a power supply module PSM, which are described later.

A third panel hole H3 may be formed (or defined) through the lower member SP. FIG. 12 shows a structure in which the third panel hole H3 has substantially the same shape and size as those of the first panel hole H1 and the second panel hole H2, however, embodiments are not limited thereto or thereby. In another example, the shape and size of the third panel hole H3 may be different from those of the first panel hole H1 and the second panel hole H2.

The housing HU may accommodate the electro-optical module EOM, the power supply module PSM, the electronic module EM, and the display panel DP. The window WM may be coupled to the housing HU to form an exterior of the electronic device EE.

The electro-optical module EOM may overlap the sensing area SA-ED. The electro-optical module EOM may receive the external input through the sensing area SA-ED or may output signals through the sensing area SA-ED. The electro-optical module EOM may include a camera module or a sensor module.

The electronic module EM may include a control module, a wireless communication module, an image input module, an audio input module, an audio output module, a memory, and an external interface module. The electronic module EM may include a main circuit board, and the modules may be mounted on the main circuit board or may be electrically connected to the main circuit board via a flexible circuit board. The electronic module EM may be electrically connected to the power supply module PSM.

The power supply module PSM may supply a power required for the overall operation of the electronic device EE. As an example, the power supply module PSM may include a conventional battery device.

FIG. 13 is a schematic cross-sectional view of the display panel DP taken along a line II-II' of FIG. 12. The display panel DP shown in FIG. 13 may be manufactured using the deposition apparatus ED (refer to FIG. 1).

Referring to FIG. 13, the display panel DP may be a light emitting display panel. FIG. 13 shows a cross-section corresponding to a representative one of pixels, for example, a cross-section corresponding to two transistors T1 and T2 and a light emitting element OLED.

The display panel DP may include the base layer BL, a circuit element layer ML disposed on the base layer BL, a display element layer EL disposed on the circuit element layer ML, and an encapsulation layer TFE disposed on the display element layer EL.

The base layer BL may include a synthetic resin layer. The base layer BL may be formed by forming the synthetic resin layer on a support substrate used in case that the display panel DP is manufactured, forming a conductive layer and an insulating layer on the synthetic resin layer, and removing the support substrate.

The circuit element layer ML may include at least one insulating layer and a circuit element. The circuit element may include a signal line and a pixel driving circuit. An insulating layer, a semiconductor layer, and a conductive layer may be formed by a coating or depositing process. For example, the insulating layer, the semiconductor layer, and the conductive layer may be patterned by a photolithography process, and thus, the circuit element layer ML may be formed.

In the embodiment, the circuit element layer ML may include a buffer layer BFL, a barrier layer BRL, and first, second, third, fourth, fifth, sixth, and seventh insulating layers 10, 20, 30, 40, 50, 60, and 70. The buffer layer BFL, the barrier layer BRL, and the first, second, third, fourth, fifth, sixth, and seventh insulating layers 10, 20, 30, 40, 50, 60, and 70 may include one of an inorganic layer and an organic layer. The buffer layer BFL and the barrier layer BRL may include the inorganic layer. At least one of the fifth, sixth, and seventh insulating layers 50, 60, and 70 may include the organic layer.

FIG. 13 illustrates an arrangement relationship of a first active A1, a second active A2, a first gate G1, a second gate G2, a first source S 1, a second source S2, a first drain DE1, and a second drain DE2 that form the first and second transistors T1 and T2 as a representative example. In the embodiment, the first active A1 and the second active A2 may include different materials from each other. The first active A1 may include a polysilicon semiconductor material, and the second active A2 may include a metal oxide semiconductor material. The first source S 1 and the first drain DE1 may have a higher doping concentration than that of the first active A1 and may function as an electrode. The second source S2 and the second drain DE2 may correspond to an area in which the metal oxide semiconductor material is reduced and may function as an electrode.

According to an embodiment, the first active A1 and the second active A2 may include substantially the same semiconductor material as each other, and a stack structure of the circuit element layer ML may be simplified.

The display element layer EL may include a pixel definition layer PDL and the light emitting element OLED. The light emitting element OLED may be an organic light emitting diode or a quantum dot light emitting diode. An anode AE may be disposed on the seventh insulating layer 70. At least a portion of the anode AE may be exposed through a pixel opening PDL-OP of the pixel definition layer PDL. The pixel opening PDL-OP of the pixel definition layer PDL may define a light emitting area PXA. A non-light-emitting area NPXA may surround the light emitting area PXA.

A hole control layer HCL and an electron control layer ECL may be commonly disposed in the light emitting area PXA and the non-light-emitting area NPXA. The light emitting layer EML may include a light emitting material and may be formed in a pattern shape to correspond to the pixel opening PDL-OP. Different from the hole control layer HCL and the electron control layer ECL, each having a film shape, the light emitting layer EML may be deposited in a different way. As an example, the hole control layer HCL and the electron control layer ECL may be commonly formed in the pixels using a mask called an open mask. The light emitting layer EML may be formed in the pattern shape to correspond to the pixel opening PDL-OP using the mask assembly according to the invention.

A cathode CE may be disposed on the electron control layer ECL. The encapsulation layer TFE may be disposed on the cathode CE. The encapsulation layer TFE may be a thin film encapsulation layer to encapsulate the display element layer EL. The encapsulation layer TFE may include a plurality of thin layers. The thin layers may include an inorganic layer and an organic layer. The encapsulation layer TFE may include an insulating layer to encapsulate the display element layer EL and a plurality of insulating layers to improve a light emitting efficiency.

In concluding the detailed description, those skilled in the art will appreciate that many variations and modifications may be made to the embodiments without substantially departing from the principles and scope of the invention. Therefore, the disclosed embodiments are used in a generic and descriptive sense only and not for purposes of limitation.

## Claims

1. A mask assembly (MSA) comprising:
a mask frame (MF) including a frame opening (OP-MF);
a first stick (ST1) disposed on the mask frame (MF), overlapping the frame opening (OP-MF), and extending in a first direction (DR1) to have a first length (L1);
a second stick (ST2) disposed on the first stick (ST1), overlapping the frame opening (OP-MF), and extending in a second direction (DR2) intersecting the first direction (DR1) to have a second length (L2) longer than the first length (L1); and
a mask (MK) disposed on the second stick (ST2) and including a mask opening (OP-MK) overlapping the frame opening (OP-MF), the second stick (ST2) comprising:
a first center portion (CST) crossing the frame opening (OP-MF); and
a first end portion (EST) extending from the first center portion (CST) in the second direction (DR2), wherein
the first end portion (EST) includes a first notch concave portion (OH1) in which a central portion of an outer side surface of the first end portion (EST) is recessed toward the first center portion (CST) when viewed in a plane, and
a maximum width of the first notch concave portion (OH1) is substantially equal to or greater than about 40% of a width of the first end portion (EST) when viewed in the plane.

2. The mask assembly (MSA) of claim 1, wherein the maximum width of the first notch concave portion (OH1) is smaller than about 80% of the width of the first end portion (EST) when viewed in the plane.

3. The mask assembly (MSA) of claim 1 or 2, wherein the first notch concave portion (OH1) comprises:
a first-first notch concave portion (OH1-a) having a substantially uniform width when viewed in the plane; and
a first-second notch concave portion (OH1-b) having a width which decreases as a distance from the first center portion (CST) decreases when viewed in the plane.

4. The mask assembly (MSA) of claim 3, wherein
the first-second notch concave portion (OH1-b) is a curved line having a substantially uniform curvature when viewed in the plane, and
the substantially uniform curvature is about 0.5 times the maximum width of the first notch concave portion (OH1) when viewed in the plane.

5. The mask assembly (MSA) of claim 3 or 4, wherein a length of the first-first notch concave portion (OH1-a) in the second direction (DR2) is substantially equal to or greater than about 8 mm and substantially equal to or smaller than about 12 mm when viewed in the plane.

6. The mask assembly (MSA) of at least one of claims 1 to 5, wherein the width of the first end portion (EST) is substantially equal to or greater than about 25 mm.

7. The mask assembly (MSA) of at least one of claims 1 to 6, wherein a minimum width of the first center portion (CST) is substantially equal to or smaller than about 5 mm.

8. The mask assembly (MSA) of at least one of claims 1 to 7, wherein a width of the first center portion (CST) in the first direction (DR1) decreases as a distance from the first end portion (EST) increases.

9. The mask assembly (MSA) of at least one of claims 1 to 8, wherein
the first end portion (EST) comprises first and second portions (NC1, NC2) protruding outward from the first center portion (CST),
the first notch concave portion (OH1) is defined between the first and second portions (NC1, NC2), and
a thickness of each of the first and second portions (NC1, NC2) is substantially uniform in the second direction (DR2) when viewed in the plane.

10. The mask assembly (MSA) of claim 9, wherein the thickness of the first portion (NC1) is substantially equal to the thickness of the second portion (NC2) when viewed in the plane.

11. The mask assembly (MSA) of at least one of claims 1 to 10, wherein
the mask include a plurality of masks,
the first stick (ST1) include a plurality of first sticks (ST1),
the second stick (ST2) include a plurality of second sticks (ST2),
the first sticks (ST1) are arranged in the second direction (DR2),
the second sticks (ST2) are arranged in the first direction (DR1), and
the masks are arranged in the second direction (DR2).

12. The mask assembly (MSA) of at least one of claims 1 to 11, wherein the mask and the mask frame (MF) comprise Invar.

13. The mask assembly (MSA) of at least one of claims 1 to 12, wherein
the first stick (ST1) comprises:
a second center portion (CST2) crossing the frame opening (OP-MF); and
a second end portion (EST2) extending from the second center portion (CST2) in the first direction (DR1),
the second end portion (EST2) includes a second notch concave portion in which a central portion of an outer side surface of the second end portion (EST2) is recessed toward the second center portion (CST2) when viewed in the plane, and
a maximum width of the second notch concave portion is substantially equal to or greater than about 40% of a width of the second end portion (EST2) when viewed in the plane.

14. The mask assembly (MSA) of claim 13, wherein the maximum width of the second notch concave portion is smaller than about 80% of the width of the second end portion (EST2) when viewed in the plane.

15. The mask assembly (MSA) of claim 13 or 14, wherein
the second end portion (EST2) comprises third and fourth portions (NC11, NC22) protruding outward from the second center portion (CST2),
the second notch concave portion is defined between the third and fourth portions (NC11, NC22), and
a thickness of each of the third and fourth portions (NC11, NC22) is substantially uniform in the first direction (DR1) when viewed in the plane.

16. The mask assembly (MSA) of claim 15, wherein the thickness of the third (NC11) portion is substantially equal to the thickness of the fourth portion (NC22) when viewed in the plane.

17. A method of manufacturing a mask assembly (MSA), in particular a mask assembly (MSA) of at least one of claims 1 to 16, the method comprising:
disposing a first stick (ST1) extending in a first direction (DR1) to have a first length (L1) on a mask frame (MF) including a frame opening (OP-MF);
disposing a second stick (ST2) comprising:
a first center portion (CST) crossing the frame opening (OP-MF), and
a first end portion (EST) extending from the first center portion (CST) in a second direction (DR2) and extending in the second direction (DR2) intersecting the first direction (DR1) to have a second length (L2) longer than the first length (L1) on the first stick (ST1);
fixing a first portion (NC1) of the first end portion (EST) by a first clamp (CLA1) and a second portion (NC2) of the first end portion (EST) by a second clamp, respectively, to apply a tensile force to the first and second portions (NC1, NC2); and
attaching a mask disposed on the second stick (ST2) and including a mask opening (OP-MK) overlapping the frame opening (OP-MF) to the mask frame (MF), wherein
the first end portion (EST) includes a first notch concave portion (OH1) in which a center portion of an outer side surface of the first end portion (EST) is recessed toward the first center portion (CST) when viewed in a plane, and
a maximum width of the first notch concave portion (OH1) is substantially equal to or greater than about 40% of a width of the first end portion (EST) when viewed in the plane.

18. The method of claim 17, wherein
the first clamp (CLA1) applies a first tensile force to the first portion (NC1), and
the second clamp applies a second tensile force greater than the first tensile force to the second portion (NC2).
